(19) Europäisches Patentamt

European Patent Office

Office européen des brevets

(11) **EP 2 635 913 B1**

(12) **EUROPÄISCHE PATENTSCHRIFT**

(45) Veröffentlichungstag und Bekanntmachung des Hinweises auf die Patenterteilung:
**11.12.2013 Patentblatt 2013/50**

(21) Anmeldenummer: **12715570.3**

(22) Anmeldetag: **13.01.2012**

(51) Int Cl.:
***G01R 33/06*** *(2006.01)* ***G01R 33/18*** *(2006.01)*

(86) Internationale Anmeldenummer:
**PCT/DE2012/000029**

(87) Internationale Veröffentlichungsnummer:
**WO 2012/097796 (26.07.2012 Gazette 2012/30)**

(54) **VERFAHREN ZUR MAGNETFELDMESSUNG MIT MAGNETOELEKTRISCHEN SENSOREN**

METHOD FOR MEASURING A MAGNETIC FIELD USING MAGNETOELECTRIC SENSORS

PROCÉDÉ DE MESURE DE CHAMP MAGNÉTIQUE AU MOYEN DE CAPTEURS MAGNÉTO-ÉLECTRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.01.2011 DE 102011008866**

(43) Veröffentlichungstag der Anmeldung:
**11.09.2013 Patentblatt 2013/37**

(73) Patentinhaber: **Christian-Albrechts-Universität zu Kiel**
**24118 Kiel (DE)**

(72) Erfinder:
• **JAHNS, Robert**
**24107 Kiel (DE)**
• **KNÖCHEL, Reinhard**
**25336 Elmshorn (DE)**
• **QUANDT, Eckhard**
**24226 Heikendorf (DE)**

(74) Vertreter: **Hansen, Jochen**
**Hansen und Heeschen**
**Patentanwälte**
**Eisenbahnstrasse 5**
**21680 Stade (DE)**

(56) Entgegenhaltungen:
**US-A1- 2010 015 918**

• **ALAN S EDELSTEIN ET AL: "Approach for sub pT, room temperature magnetic sensors", SENSORS, 2010 IEEE, IEEE, PISCATAWAY, NJ, USA, 1. November 2010 (2010-11-01), Seiten 620-622, XP031977848, DOI: 10.1109/ICSENS. 2010.5690118 ISBN: 978-1-4244-8170-5**
• **GREVE HENRY ET AL: "Giant magnetoelectric coefficients in (Fe90Co10)78Si12B10-AlN thin film composites", APPLIED PHYSICS LETTERS, AIP, AMERICAN INSTITUTE OF PHYSICS, MELVILLE, NY, US, Bd. 96, Nr. 18, 3. Mai 2010 (2010-05-03), Seiten 182501-182501, XP012131006, ISSN: 0003-6951, DOI: 10.1063/1.3377908**

EP 2 635 913 B1

**Beschreibung**

Die Erfindung betrifft ein Verfahren zur Messung von zeitlich veränderlichen Magnetfeldern mit magnetoelektrischen Sensoren.

Magnetoelektrische, auch ME-Sensoren genannt, Sensoren eignen sich zur Detektion u. a. kleiner zeitlich veränderlicher Magnetfelder, die z.B. durch Ströme in biologischen Organismen hervorgerufen werden. Sie gelten als aussichtsreiche Kandidaten zur Ablösung sogenannter SQUIDS, die auf Supraleitung basieren und zu diesem Zweck beständiger und extremer Kühlung bedürfen. ME-Sensoren sind Gegenstand aktueller Forschung u. a. im Hinblick auf die Entwicklung biomagnetischer Schnittstellen, die zunächst in der medizinischen Diagnostik, z.B. MEG, MKG, und womöglich zukünftig auch in der Prothesensteuerung oder sogar zur allgemeinen "Gedankensteuerung" von Computern und Maschinen eingesetzt werden könnten.

Das Grundkonzept der Funktionsweise aller ME-Sensoren liegt in der mechanischen Kraftkopplung von magnetostriktiven und piezoelektrischen Materialien.

Magnetostriktive Materialien, z.B. Ferromagnetische Übergangsmetalle, Fe, Ni, Co, und deren Legierungen, Verbindungen der Seltenen Erden Tb, Dy, Sm mit den ferromagnetischen Übergangsmetallen, z.B. TbFe2, SmFe2, oder auch ferromagnetische Gläser vorwiegend enthaltend die Elemente Eisen, Kobalt, Bor oder Silizium in variierenden Anteilen, erfahren eine reversible Längenänderung in der Richtung eines auf sie einwirkenden Magnetfeldes. Diese Längenänderung wird der Ausrichtung von Elementarmagneten entlang des äußeren Magnetfeldes zugeschrieben und kann nach heutigem Wissen bis zu 2,5 mm/m = 2500 ppm bei Raumtemperatur betragen.

Koppelt man ein magnetostriktives Material mechanisch fest an ein Piezoelektrikum, z.B. Bleizirkonattitanat (PZT), Polyvinylidenfluorid (PVDF), Aluminiumnitrid (AIN), so kann die magnetostriktive Ausdehnung eine Kraft ausüben, die zu einer strukturellen Ladungsverschiebung, Polarisation, im Piezoelektrikum führt, was wiederum eine messbare Piezospannung nach sich zieht. Diese Spannung kann als Maß für die magnetische Feldstärke elektronisch erfasst und ausgewertet werden.

Es gibt eine Vielfalt von verschieden ausgeführten ME-Sensoren. Zu den einfachsten zählt ein mehrlagiges Schichtsystem umfassend wenigstens eine Lage aus einem magnetostriktiven Material mit einer unmittelbar darauf angeordneten piezoelektrischen Lage und einer Metallisierungslage als Elektrode auf dem Piezomaterial. Das Schichtsystem hat üblich die Form eines Streifens, der an zumindest einem Ende befestigt ist. Unter der Einwirkung eines Magnetfeldes entlang der Streifenlänge verbiegt sich der Streifen infolge der unterschiedlichen Materialausdehnung, und das somit gleichzeitig verbogene Piezomaterial wird elektrisch polarisiert. Die elektrische Potenzialdifferenz zwischen den beiden Streifenflachseiten lässt sich als Messspannung abgreifen.

Magnetostriktive, auch MS genannt, und piezoelektrische, auch PE genannt, Materialschichten können mit an sich bekannten Beschichtungstechniken aufeinander und/oder auf vorbestimmten Substraten abgeschieden werden. Die Herstellung von ME-Sensoren ist insoweit mit Prozessen der Silizium-Technologie kompatibel; insbesondere sind integrierte ME-Sensoren etwa in MEMS-Bauweise, Micro Electrical Mechanical Systems, herstellbar. Aber auch die getrennte Erzeugung von MS und PE Folien und das anschließende Verkleben beider zu einer ME-Folie ist geeignet, Magnetfeldsensoren nach dem beschriebenen Prinzip zu erzeugen.

Alle ME-Sensoren sind mechanische Oszillatoren. Unter Einwirkung eines periodischen Magnetfeldes definierter Frequenz zeigen sie ein erzwungenes mechanisches Schwingungsverhalten. Erfolgt die Anregung dabei mit der mechanischen Resonanzfrequenz des ME-Sensors, dann rufen selbst sehr kleine Magnetfeldstärken sehr große Messspannungen hervor.

Biologisch erzeugte Magnetfelder weisen typisch nur Frequenzen der Größenordnungen 1 Hz bis ungefähr 100 Hz auf. Demgegenüber liegen die Resonanzfrequenzen gängiger ME-Sensoren gewöhnlich bei etlichen 100 Hz bis zu einigen 100 kHz. Weitere Miniaturisierung der ME-Sensoren, etwa durch Integration in MEMS, lässt eher noch höhere Resonanzfrequenzen erwarten.

Das Verhältnis der im ME-Sensor hervorgerufenen elektrischen Feldstärkeamplitude zur anregenden magnetischen Feldstärkeamplitude wird als ME-Koeffizient, $\alpha_{ME}$, bezeichnet. Zwischen Messungen von Magnetfeldern im Resonanzfall und weit außerhalb der Resonanz variiert der ME-Koeffizient typisch um zwei bis drei Größenordnungen.

Es wäre also wünschenswert, zur Detektion kleiner Magnetfelder mit vorab bekannter Frequenz jeweils ME-Sensoren mit einer passenden Resonanzfrequenz zur Verfügung zu haben. Tatsächlich gibt es Bemühungen, beispielsweise ME-Sensoren der eingangs beschriebenen Streifenbauart durch das Anordnen zusätzlicher Massen auf niedrigere Resonanzfrequenzen einzustellen. Doch der ME-Koeffizient weist auch dann noch ein scharf begrenztes Maximum bei der Resonanzfrequenz auf, so dass benachbarte Frequenzen deutlich schwächere Signale liefern. Selbst ein Array von ME-Sensoren, die alle verschiedene Resonanzfrequenzen besitzen, z.B. vorgeschlagen in der US 2010/0015918 A1, wobei die ME-Sensoren als Receiver magnetischer Trägerwellen gedacht sind und das Array eine Mehrzahl von Datenkanälen realisiert, führt nicht unbedingt zu einer ausreichend dichten Abtastung eines Frequenzbandes auf dem ein a priori unbekanntes Signal erfasst werden soll. Überdies wäre ein Array mit Hunderten von ME-Sensoren praktisch nur als integriertes Mikrosystem herzustellen, und die Verringerung der mechanischen Resonanzfrequenzen von kHz-Oszillatoren auf den biomagnetischen Bandbereich, $\leq$ 100 Hz, ist dabei kaum noch ausführbar.

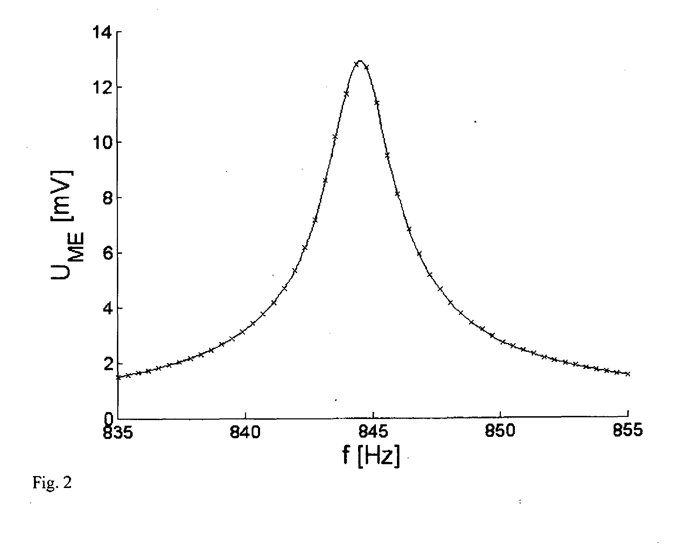

Aus Alan S. Edelstein, et al. "Approach for sub pT, Room Temperature Magnetic Sensors", Sensors, 2010 IEEE, IEEE, Piscataway, NJ, USA vom 01. November 2010, Seiten 620 - 622 ist ein Verfahren zur Messung eines zeitlich veränderlichen Magnetfeldes mit einem magnetoelektrischen Sensor bekannt, bei dem das Magnetfeld - in der Arbeit wird ein Testfeld mit Frequenz 10 Hz benutzt - mittels einer rotierenden Scheibe, die als "magnetic flux concentrator" wirkt, moduliert wird, um 1/f-Rausch zu unterdrücken. Die Modulation erfolgt mit der Rotationsfrequenz der Scheibe, 76 Hz, und bewirkt eine Frequenzumsetzung des Magnetfeldes, und somit des ME-Sensorsignals, auf 66 und 86 Hz. Edelstein et al. regen auch an, die Frequenzumsetzung bis in die mechanische Resonanzfrequenz des ME-Sensors vorzunehmen. Da diese jedoch nach der dort gezeigten Fig. 2 zwischen 200 und 300 kHz liegt, erscheint die Verwendung einer rotierenden Scheibe als Megnetflußkonzentrator dafür prinzipiell nicht geeignet.

Aus Greve, Henry et al. "Giant magnetoelectric coefficients in (Fe90Co10)78Sil2B10-AlN thin film composites", Applied physics letters, AIP, American Institute of Physics, Melville, NY, US vom 03. Mai 2010, Seiten 182501 - 182501 ist ferner ein thin film magnetoelectric composite bekannt, mit dessen Hilfe die Realisierung eines 3-dimensionalen Vektorfeldsensors möglich erscheint, da ein Sensorelement mit einer bevorzugten Sensitivität in nur einer Dimension hergestellt werden könnte.

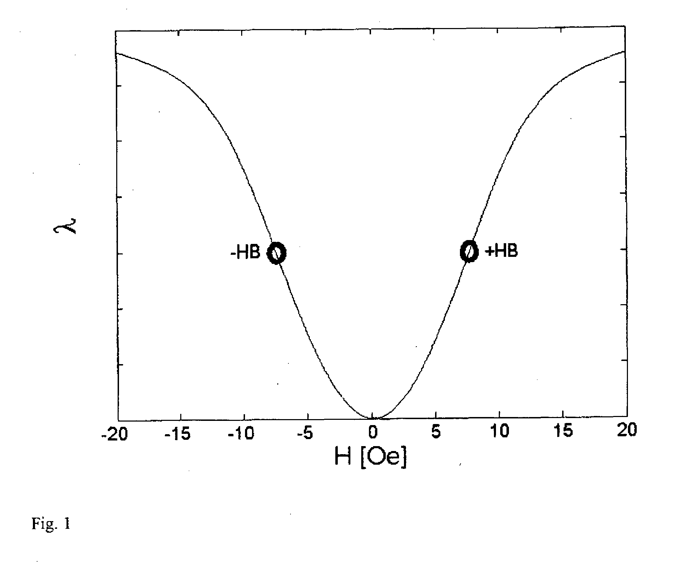

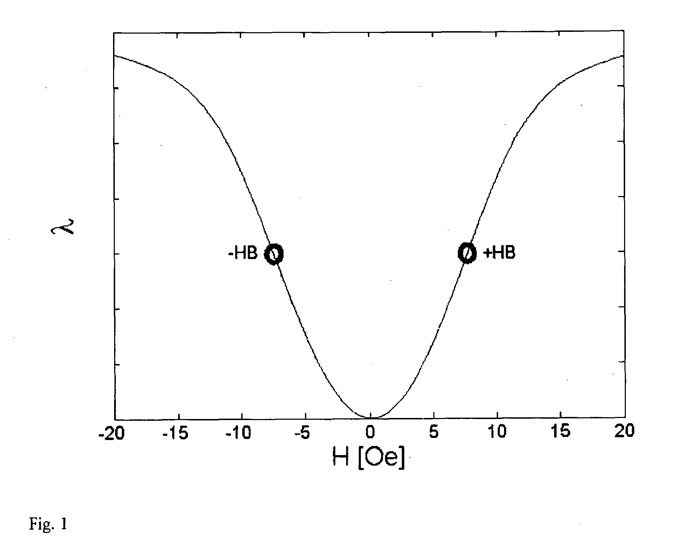

Gewöhnlich werden ME-Sensoren auch außerhalb ihrer mechanischen Resonanz betrieben. Da man an einer möglichst großen Messdynamik, einem möglichst großen Signal-Rausch-Verhältnis und an der Linearität der Spannungsantwort auf das zu messende magnetische Wechselfeld interessiert ist, wählt man für den ME-Sensor einen Arbeitspunkt im linearen Bereich der Magnetostriktionskennlinie, siehe Fig. 1. Diese Kennlinie $\lambda$ (H) beschreibt die Längenausdehnung $\lambda$ des MS-Materials unter der Wirkung eines Magnetfeldes H und ihr Verlauf ist stets symmetrisch, da beide Feldrichtungen denselben Effekt auf das Material haben. Die Funktion $\lambda$ (H) weist ohne Feld zunächst einen parabolischen Anstieg auf, ist aber zugleich nach oben beschränkt, bei Erreichen der Sättigungsmagnetisierung. Sie besitzt folglich einen Wendepunkt $H_B$, in dem der lineare Term der Taylor-Entwicklung von $\lambda$ um $H=H_B$ dominiert und wo zugleich die größte Steigung vorliegt. Um den ME-Sensor in diesem günstigen Arbeitspunkt zu betreiben, wird vorzugsweise ein konstantes Bias-Magnetfeld der Stärke $H_B$ durch das geeignete Anordnen von Stromleitern oder Permanentmagneten angelegt.

Ein solches Bias-Magnetfeld ist jedoch in der Anwendungspraxis nicht unproblematisch. Gerade bei mehreren ME-Sensoren in enger Nachbarschaft zueinander können wechselseitige Einflüsse der magnetischen Bias-Felder auftreten, insbesondere dann, wenn die Felder nach dem Biot-Savart-Gesetz erzeugt werden und die Ströme über Zuleitungen zu führen sind. Permanentmagnetische Bias-Felder sind energetisch günstiger, erfordern aber schlichtweg das Anordnen einer ausreichenden Menge magnetischen Materials, um geeignete Feldstärken zu erzielen. Man ist deshalb sehr darum bemüht, Schichtsysteme und Laminate aus magnetostriktiven und piezoelektrischen Materialien für ME-Sensoren zu entwickeln, die mit möglichst kleinen magnetischen Bias-Feldstärken in den Arbeitspunkt zu bringen sind. Beispielsweise werden solche Schichtsysteme in der Arbeit von Zhai et al., "Giant magnetoelectric effect in Metglas/ polyvinylidene-fluoride laminates", APPLIED PHYSICS LETTERS 89, 083507 (2006) und in der US 7,023,206 B2 beschrieben. Gleichwohl ist ein Bias-Feld von einigen Oersted, veraltete cgs-Einheit der magnetischen Feldstärke: 1 Tesla = $\mu$0 x 10.000 Oersted, immer noch erforderlich.

Es wäre wünschenswert, völlig auf konstante Bias-Felder verzichten zu können, insbesondere auch keine Vorkehrungen zu deren angemessener Einrichtung während der ME-Sensor-Produktion oder während des Messbetriebs mehr treffen zu müssen.

Die Erfindung stellt sich die Aufgabe, ein Verfahren zur Messung von Magnetfeldern mit einem beliebigen ME-Sensor über frei wählbare, insbesondere biomagnetische, Frequenzbänder mit sehr hoher, frequenzunabhängiger Sensorempfindlichkeit vorzuschlagen.

Die Aufgabe wird gelöst durch ein Verfahren mit den Merkmalen des Hauptanspruchs. Die Unteransprüche geben vorteilhafte Ausgestaltungen des Verfahrens an. Ein Nebenanspruch ist auf die Messung eines Magnetfeldes mit einem Array von ME-Sensoren gerichtet.

Das erfindungsgemäße Verfahren nutzt die mechanische Resonanz des ME-Sensors sowie den quadratischen Verlauf der Magnetostriktionskennlinie $\lambda$ (H) $\approx$ a $H^2$ + $O(H^4)$ in der Umgebung von H = 0, also in Abwesenheit eines Bias-Magnetfeldes. Die Proportionalitätskonstante a ist dabei für jeden vorgegebenen ME-Sensor bekannt oder auch direkt messbar.

Ein beliebiges zu messendes Signal mit harmonischer Abhängigkeit von der Zeit t

$$(1) \qquad H_{mess}(t) = H_{mess0} \times \cos(2\pi\, f_{mess}\, t)$$

wird erfindungsgemäß mit einem zusätzlich generierten harmonischen Modulationssignal

$$(2) \qquad H_{mod}(t) = H_{mod0} \times \cos(2\pi \, f_{mod} \, t)$$

auf dem ME-Sensor superponiert. Amplitude $H_{mod0}$ und Frequenz $f_{mod}$ des Modulationssignals liegen dabei in der Hand des Anwenders. Das Modulationssignal wird durch einen Frequenzgenerator erzeugt und vorzugsweise über eine Antenne auf den ME-Sensor als elektromagnetische Welle eingestrahlt. Alternativ kann das Modulationsmagnetfeld auch durch eine Spule um den ME-Sensor generiert werden. Die Unbekannten $H_{mess0}$ und $f_{mess}$ sind als Amplitude und Frequenz des Messsignals zu bestimmen.

Der ME-Sensor "sieht" das Summensignal $H_{mess}(t) + H_{mod}(t)$ durch die Längenänderung des magnetostriktiven Materials in der Form

$$(3) \qquad \lambda(t) \approx a \, (H_{mess}(t))^2 + a \, (H_{mod}(t))^2 + 2 \, a \, H_{mess}(t) \times H_{mod}(t) + O(H^4)$$

Der dritte Term von Gleichung (3) ist der führende Intermodulationsterm, auf den es ankommt.

$$(4) \qquad 2 \, a \, H_{mess}(t) \times H_{mod}(t)$$

$$= a \, H_{mess0} \times H_{mod0} \, [\cos(2\pi \, (f_{mess} + f_{mod}) \, t) + \cos(2\pi \, (f_{mess} - f_{mod}) \, t)]$$

Der Anwender kann somit $f_{mod}$ so einrichten, dass $f_{mess} + f_{mod}$ oder $f_{mess} - f_{mod}$ genau der Resonanzfrequenz des ME-Sensors entspricht. Soll ein bestimmtes Frequenzband des Messignals erfasst werden, so wird $f_{mod}$ in einem entsprechend komplementären Frequenzband variiert, oder auch: gewobbelt.

Die Resonanzfrequenz $f_R$ eines ME-Sensors kann stets als bekannt vorausgesetzt werden. Im Zweifel kann ein einfacher Vorversuch - insbesondere das Einstrahlen und Wobbeln des Modulationssignals in Abwesenheit eines Messsignals über den in Frage kommenden Frequenzbereich - die Lage der Resonanzfrequenz schnell ermitteln.

Soll also ein Messsignal im Frequenzband $f_{min} \le f_{mess} \le f_{max}$ detektiert werden, ist das Modulationssignal über einen der beiden komplementären Frequenzbereiche

$$(5) \qquad f_R - f_{max} \le f_{mod} \le f_R - f_{min}$$

oder

$$(6) \qquad f_R + f_{min} \le f_{mod} \le f_R + f_{max}$$

zu variieren, wodurch der ME-Sensor immer resonant angeregt wird. Es findet durch die Mischung mit dem Modulationssignal eine Frequenzumsetzung des Messsignals in die Sensorresonanzfrequenz statt.

Das Spannungssignal am Sensorausgang wird allein vom Intermodulationsterm mit der Amplitude $H_{mess0} \times H_{mod0}$ beherrscht, weil die übrigen Terme in Gleichung (3) typisch Frequenzen deutlich außerhalb der Resonanzfrequenz des Sensors besitzen und deren Beiträge zur Spannung daher vernachlässigt werden können. Die messbare Spannungsamplitude kann direkt in die Magnetfeldamplitude übersetzt werden, und Division durch den bekannten Wert $H_{mod0}$ liefert den gesuchten Wert $H_{mess0}$.

Es soll hier besonders hervorgehoben werden, dass das erfindungsgemäße Verfahren ohne jedes Bias-Magnetfeld auskommt. Es funktioniert vielmehr am besten bei H = 0, wo der quadratische Anteil der Magnetostriktionskennlinie dominiert.

Die Amplitude $H_{mod0}$ des Modulationssignals ist ein vom Anwender frei wählbarer Parameter, mit dem er aber die Messdynamik noch erhöhen kann. Die

Ausgangsspannung des ME-Sensors steigt linear mit wachsender Modulationsamplitude an, allerdings nur etwa bis zum Wert $H_{mod0} = H_B$. Wie bereits in der Diskussion des Standes der Technik erwähnt ist die Feldstärke $H_B$ gerade durch den Wendepunkt der Magnetostriktionskennlinie $\lambda$ (H) gekennzeichnet. Sie gibt die Stärke des Bias-Magnetfeldes an, das man anlegen müsste, um mit dem gegebenen ME-Sensor außerhalb seiner Resonanz im optimalen Arbeitspunkt zu messen.

Es ist also eine bevorzugte Ausgestaltung der Erfindung, das Modulationssignal mit einer Amplitude einzurichten, die der magnetischen Bias-Feldstärke des ME-Sensors im Betrieb gemäß Stand der Technik entspricht. Da das Modulationssignal auf den Sensor eingestrahlt werden kann, sind dennoch günstigerweise keinerlei apparative Vorkehrungen am Sensor selbst oder gar bei seiner Herstellung zu treffen.

Die Erfindung soll nachfolgend anhand eines Ausführungsbeispiels und einer Figuren näher erläutert werden. Dabei zeigt:

Fig. 1     den qualitativen Verlauf der Magnetostriktionskennlinie $\lambda$ (H);

Fig. 2     den für den Sensor des Ausführungsbeispiels ermittelten Verlauf seiner mechanischen Resonanzkurve;

Fig. 3     das Ergebnis einer Voruntersuchung zur Ermittlung des optimalen Arbeitspunktes bzw. Bias-Magnetfeldes für den Sensor des Ausführungsbeispiels;

Fig. 4     das Ergebnis einer Frequenzanalyse des Sensorsignals, ME-Spannung $U_{ME}$, wenn die Frequenz des Messsignals $f_{mess}$ der Resonanzfrequenz des Sensors entspricht;

Fig. 5     wie Fig. 4, jedoch beträgt die Frequenz des zu messenden Magnetfeldes $f_{mess}$ = 15 Hz;

Fig. 6     Ergebnis der Messung des Signals aus Fig. 5 (15 Hz) mit dem erfindungsgemäßen Verfahren und ohne Bias-Magnetfeld.

Für das Ausführungsbeispiel wird ein ME-Sensor in Streifenbauform mit einer Fläche von 20x2 mm$^2$ verwendet, der an einem Ende des Streifens fest eingespannt ist. Die unterste Schicht des Sensors besteht aus einem 130 $\mu$m dicken Siliziumträger, auf dem sich ein 300 nm dicker Molybdän-Film befindet. Die darüber liegende Schicht besteht aus 1800 nm dickem piezoelektrischem Aluminiumnitrid. Darauf befindet sich eine 1750 nm dicke magnetostriktive Schicht aus metallischem Glas (FeCoSiB). Die ME-Spannung wird zwischen der Molybdän-Schicht und der magnetostriktiven Schicht abgegriffen und mit einem Lock-In-Verstärker bzw. Spektrumanalysator gemessen. Das Modulationsfeld wird mit einer Luftspule um den Sensor erzeugt und das Messsignal mit einem Helmholtz-Spulenpaar.

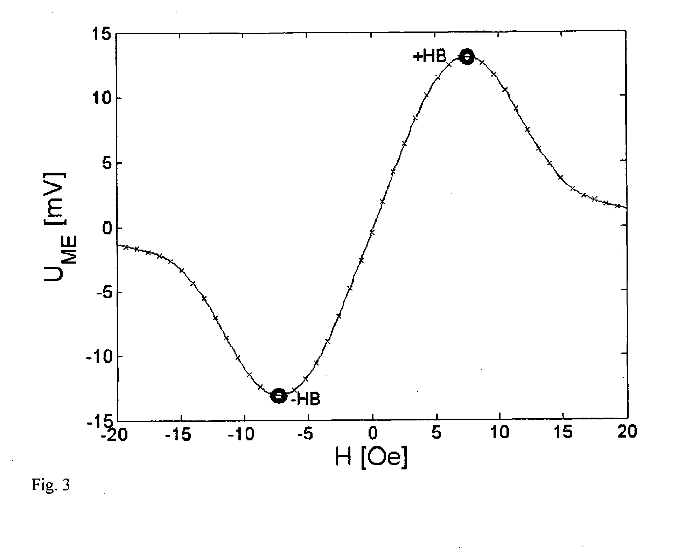

Die Magnetostriktionskennlinie $\lambda$ (H) des Beispielsensors verläuft qualitativ wie in Fig. 1 dargestellt. Gut zu erkennen sind der Parabelverlauf in Abwesenheit eines Magnetfeldes, kein Bias, H = 0, und die beiden Wendepunkte bei H = $\pm$ $H_B$. Die Kurve in Fig. 1 kann als Stammfunktion der Messkurve in Fig. 3 berechnet werden.

Zur Bestimmung der mechanischen Resonanz des ME-Sensors wird die Frequenz eines Messsignals über einen Frequenzbereich variiert, in dem die Resonanzfrequenz liegen muss. Die Magnetfeldstärke beträgt hier $H_{mess0}$ = 0,125 Oe. Die ME-Spannung zeigt ein scharfes Maximum bei $f_R$ = 844 Hz, wie gezeigt in Fig. 2. Für den herkömmlichen ME-Koeffizienten im Resonanzfall ergibt sich hiernach

$$(7) \qquad \alpha_{ME} = \frac{U_{ME}}{L \cdot H_{AC}} = \frac{12.9\,mV}{1.8 \cdot 10^{-4}\,cm \cdot 12.5 \cdot 10^{-6} \cdot 10^4\,Oe} = 577.33\,\frac{V}{cmOe}\,,$$

wobei die elektrische Feldstärke der in einem Plattenkondensator mit Plattenabstand L, Dicke der piezoelektrischen Schicht des Sensors = 1,8 $\mu$m, entspricht.

Während der ME-Sensor durch das Messsignal mit $H_{mess0}$ = 0,125 Oe und $f_{mess}$ = 844 Hz in der mechanischen Resonanz angeregt wird, kann ein Bias-Magnetfeld entlang der magnetostriktiven Schicht des Sensors angelegt und variiert werden, um den optimalen Arbeitspunkt nach dem Stand der Technik zu bestimmen. Aus Fig. 3 ist ersichtlich, dass die größte Sensorspannung $U_{ME}$ bei einer Feldstärke $H_B$ = $\pm$ 7,36 Oe zu erhalten ist.

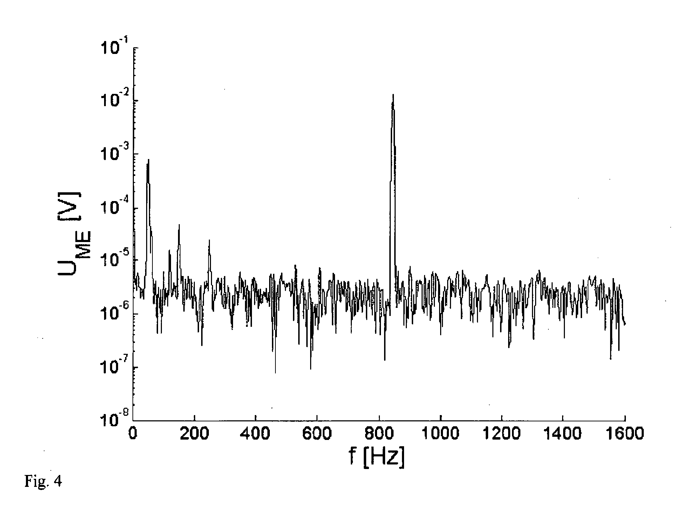

Die Figuren 4 bis 6 zeigen jeweils die gemessene Sensorspannung $U_{ME}$ zerlegt nach Frequenzen mit einem Spektrumanalysator. Man beachte die logarithmische Einteilung der Ordinate. Fig. 4 zeigt die Frequenzkomponenten der ME-Spannung für das Messsignal mit $H_{mess0} = 0,125$ Oe und $f_{mess} = 844$ Hz unter gleichzeitigem Anlegen eines konstanten Bias-Magnetfeldes von $H_B = 7,36$ Oe. Deutlich erkennt man das ausgeprägte Maximum bei der mechanischen Resonanzfrequenz des ME-Sensors sowie drei kleine Nebenmaxima bei Vielfachen der Netzfrequenz von 50 Hz.

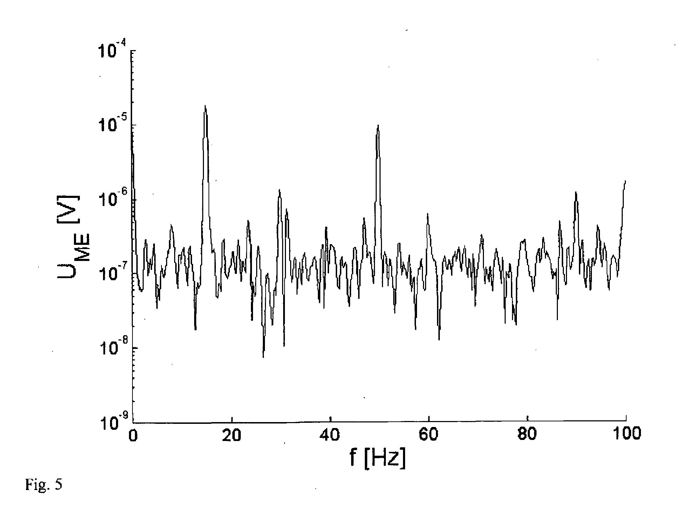

In Fig. 5 liegt dasselbe Bias-Magnetfeld $H_B = 7,36$ Oe an, ebenso ist $H_{mess0} = 0,125$ Oe, nur die Messfrequenz wird hier auf $f_{mess} = 15$ Hz verringert. Die ME-Spannungen bei 15 Hz und bei Netzfrequenz sind vergleichbar groß im Bereich um 10 $\mu$V; das Rauschen liegt eine Größenordnung darunter.

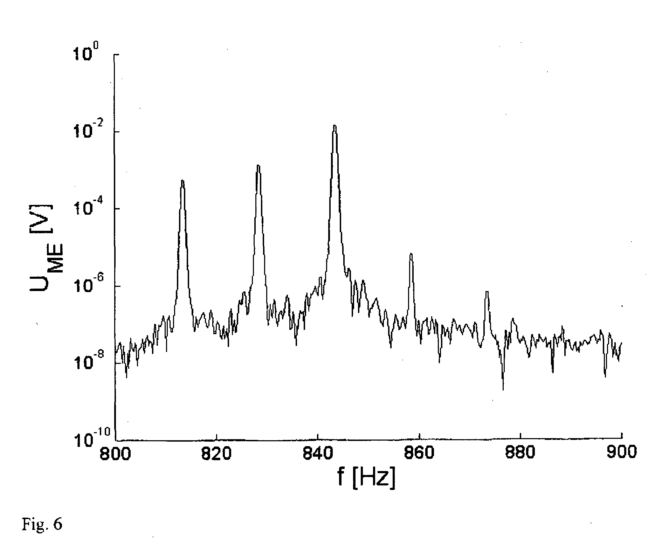

Schließlich wird das Messsignal aus Fig. 5 mit den Mitteln der Erfindung detektiert und das Ergebnis in Fig. 6 wiedergegeben. Am Sensor liegt nun kein Bias-Magnetfeld an. Das erfindungsgemäße Modulationssignal ist durch $H_{mod0} = 6,72$ Oe und $f_{mod} = 829$ Hz beschrieben und wird dem Messsignal auf dem Sensor überlagert. $H_{mod0}$ wird hier exemplarisch knapp unterhalb des optimalen Wertes $H_B = 7,36$ Oe gewählt. Auf den genauen Wert von $H_{mod0}$ kommt es ansonsten nicht an, er muss nur bekannt sein.

Fig. 6 zeigt nun drei Maxima der ME-Spannung, von denen eines (bei 829 Hz) unmittelbar vom informationslosen, bekannten Modulationssignal herrührt. Es könnte in der Auswertung durch bekannte Maßnahmen unterdrückt werden. Die beiden anderen Maxima liegen bei 829 Hz - 15 Hz = 814 Hz und bei 829 Hz + 15 Hz = 844 Hz = $f_R$, wobei die ME-Spannung des letzteren die des anderen Maximums um eine Größenordnung übersteigt.

Durch Variieren der Modulationsfrequenz in einem Bereich um 829 Hz kann keine ME-Spannung erzielt werden, die bei 844 Hz einen gleich großen oder größeren Wert als den gezeigten annimmt. Erst in der Umgebung von 859 Hz wird dies wieder möglich. Durch Wobbeln von $f_{mod}$ über einen Frequenzbereich unterhalb oder oberhalb von $f_R$, komplementäre Frequenzbereiche, wird der Resonanzfall des Sensors im superponierten Magnetfeld eindeutig identifiziert und somit auch der Wert von $f_{mess}$.

Der Resonanzanteil der messbaren ME-Spannung liegt im Beispiel der Fig. 6 bei 13,3 mV, also drei Größenordnungen über dem Messwert $U_{ME}$ desselben

Messsignals im Beispiel der Fig. 5, das die Messung nach dem Stand der Technik repräsentiert. Konvertiert man $U_{ME}$ z.B. über eine Kalibrierkurve in die Magnetfeldamplitude $H_{sup}$, so ergibt sich $H_{mess0} = H_{sup}/H_{mod0}$ und die Messaufgabe ist erfüllt.

Der unmittelbare Gewinn durch das erfindungsgemäße Verfahren besteht in einem erheblich vergrößerten Signal-Rausch-Abstand und in der Möglichkeit, auf ein konstantes Bias-Feld zu verzichten. Darüber hinaus kann der ME-Sensor über jede beliebige mechanische Resonanzfrequenz verfügen, die nur einmal ermittelt werden muss.

Die soweit beschriebene Erfindung stößt dann auf Schwierigkeiten, wenn es um die Erfassung niederfrequenter Messsignale, $f_{mess} \approx$ wenige Hertz, geht. In diesem Fall wäre für das Modulationssignal eine Frequenz $f_{mod} \approx f_R$ vorzusehen, was zur Folge hätte, dass das informationslose Modulationssignal den größten Beitrag zur Sensorspannung liefern würde.

Tatsächlich sollte $f_{mod}$ stets einen gewissen Abstand zu $f_R$ halten. Die Resonanzkurve $U_{ME}$ (H) mit H = H (f), siehe Fig. 2, zeigt einen Lorentz-Verlauf bezüglich der Frequenz, mit der das Magnetfeld H bei konstanter Amplitude variiert wird. Wenn $\Delta f > 0$ die Halbwertsbreite dieser Kurve bezeichnet, sollte mindestens

$$(8) \qquad | f_{mod} - f_R | > \Delta f$$

gewährleistet sein. Somit sind Messsignale mit $|f_{mess}| < \Delta f$ zunächst nicht zugänglich.

Glücklicherweise kann man in dieser Situation auf das Konzept eines Bias-Feldes zurückkommen und sich einen anderen Arbeitspunkt des ME-Sensors wählen. Die Bias-Feldstärke sollte dabei so eingerichtet werden, dass eine höhere Ordnung als die quadratische den Verlauf der Magnetostriktionskennlinie im Arbeitspunkt, hier als $H_W$ bezeichnet, beherrscht, also etwa

$$(9) \qquad \lambda (H = H_W) \approx c_1 (H_W + dH) + c_2 (H_W + dH)^2 + c_3 (H_W + dH)^3$$

mit $c_1, c_2 \ll c_3$ und dH als dem zeitlich veränderlichen Magnetfeldanteil. Superponiert man auch hier das zu messende, veränderliche Magnetfeld mit dem Modulationsfeld auf dem ME-Sensor, so hat man durch die Wahl von $f_{mod}$ die Möglichkeit, eine der entstehenden Mischfrequenzen $(2 f_{mess} + f_{mod})$, $(2 f_{mess} - f_{mod})$, $(f_{mess} + 2 f_{mod})$ oder $(f_{mess} - 2 f_{mod})$ mit der Sensorresonanzfrequenz zur Deckung zu bringen. Insbesondere kann man unter Beachtung von Gleichung (8) nun Messsignale im Bereich $\Delta f/2 < |f_{mess}| < \Delta f$ detektieren. Reicht dem Anwender dies noch nicht aus, so kann er noch nach einem anderen Arbeitspunkt $H_W$ mit einer höheren führenden Ordnung von $\lambda$ (H) Ausschau halten. Es steht zu erwarten, dass er solche Arbeitspunkte nur für $H_W > H_B$ - also jenseits des Wendepunktes - finden wird.

Die vorstehende Diskussion betrifft die Verwendung eines Bias-Magnetfeldes zusammen mit der erfindungsgemäßen Frequenzumsetzung in die Sensorresonanz dann und nur dann, wenn niederfrequente Messsignale erfasst werden sollen, die kleiner als die Halbwertsbreite der Sensorresonanzkurve sind. In allen anderen Messanwendungen - und diese sind die gängigen - ist ein Bias-Magnetfeld nunmehr völlig verzichtbar.

Dies vereinfacht bereits erheblich die Fertigung eines ME-Sensorarrays, insbesondere in der Mikrosystemtechnik, z.B. als Chip. Obendrein werden auch keine besonderen Anforderungen an die Resonanzfrequenzen der einzelnen ME-Sensoren im Array gestellt. Wünscht man mit dem Array ortsaufgelöste Messungen vorzunehmen, so wäre es natürlich vorteilhaft, wenn alle Sensoren dasselbe Resonanzverhalten zeigten und simultan durch das Modulationsfeld angeregt werden könnten. Doch selbst wenn es fertigungsbedingte Unterschiede zwischen den Sensoren gibt, werden diese beim Wobbeln des Modulationsfeldes irrelevant, bzw. in der Auswertung identifizierbar und somit kompensierbar, wenn die Resonanzfrequenzen alle durch die gewählte Wobbelbandbreite getroffen werden können.

Und selbst größere Unterschiede der Resonanzfrequenzen im Array - wie sie sich wohl die eingangs genannte US 2010/0015918 A1 für Datenübertragungszwecke vorstellt - können sinnvoll sein, wenn man daran interessiert ist, dass zu einem gegebenen Zeitpunkt nur ein bestimmter Sensor des Arrays ein Signal detektieren soll. Beispielsweise könnte ein beliebige Informationen tragendes, etwa im Sinne der US 2010/0015918 A1 amplitudenmoduliertes, magnetisches Wechselfeld definierter Frequenz durch Anwendung der hier beschriebenen Erfindung auf einen vorbestimmten Sensor, hier: Datenkanal, geführt werden. Der Wechsel auf einen anderen Datenkanal würde dann einfach durch Ändern der Modulationsfrequenz, ggf. unter Anpassung der Modulationsamplitude, geschehen.

Bevorzugt kann das Verfahren zur Messung eines Magnetfeldes mit einer Anordnung erfolgen, die eine Anzahl N magnetoelektrischer Sensoren aufweist, wobei die Sensoren vorbekannte mechanische Resonanzfrequenzen $f_R(i)$, i = 1, ..., N besitzen und das Magnetfeld eine harmonische Zeitabhängigkeit mit der vorbekannten Frequenz $f_M$ aufweist, wobei durch Superponieren des Magnetfeldes mit einem Modulationsmagnetfeld mit der Frequenz $f_{mod} = f_R(i) + f_M$ oder $f_{mod} = f_R(i) - f_M$ der durch Index i bezeichnete Sensor zur Detektion des Magnetfeldes bestimmt wird.

## Patentansprüche

1. Verfahren zur Messung eines zeitlich veränderlichen Magnetfeldes mit einem magnetoelektrischen Sensor mit mechanischer Resonanzfrequenz $f_R$, wobei das Magnetfeld wenigstens einen Anteil mit harmonischer Zeitabhängigkeit mit der zu bestimmenden Messsignalamplitude $H_{mess0}$ und der zu bestimmenden Messsignalfrequenz $f_{mess}$ in einem vorbekannten Frequenzintervall $f_{min} < f_{mess} < f_{max}$ aufweist, **gekennzeichnet durch** die Schritte:

   a. Superponieren des Magnetfeldes mit einem Modulationsmagnetfeld mit harmonischer Zeitabhängigkeit mit der vorbekannten Modulationsamplitude $H_{mod0}$ und einer wählbaren Modulationsfrequenz auf dem Sensor,
   b. Variieren, Wobbeln, der Modulationsfrequenz über ein **durch** die vorbekannten Intervallgrenzen $f_{min}$, $f_{max}$ und die Resonanzfrequenz des Sensors $f_R$ bestimmtes, komplementäres Frequenzintervall,
   c. Messen des Sensorsignals für jede gewählte Modulationsfrequenz,
   d. Aufsuchen der wenigstens einen Modulationsfrequenz $f_{mod}$, die zu einem Sensorsignal in der mechanischen Resonanz des Sensors führt,
   e. Berechnen der Messsignalfrequenz $f_{mess}$ aus der zuvor bestimmten Modulationsfrequenz $f_{mod}$ und aus der Resonanzfrequenz des Sensors $f_R$
   f. Übersetzen des Sensorsignals bei der Modulationsfrequenz $f_{mod}$ in die superponierte Magnetfeldamplitude $H_{sup}$,
   g. Berechnen der Messsignalamplitude $H_{mess0}$ aus der superponierten Magnetfeldamplitude $H_{sup}$ und der Modulationsamplitude $H_{mod0}$.

2. Verfahren nach Anspruch 1, **dadurch gekennzeichnet, dass** der Arbeitspunkt des Sensors in seiner Magnetostriktionskennlinie so festgelegt ist, dass seine Spannungsantwort in führender Ordnung quadratisch von der magnetischen Feldstärke abhängt.

3. Verfahren nach Anspruch 2, **dadurch gekennzeichnet, dass** das komplementäre Frequenzintervall gemäß $f_R - f_{max} < f_{mod} < f_R - f_{min}$ oder $f_R + f_{min} < f_{mod} < f_R + f_{max}$ festgelegt und der wenigstens eine Anteil des Magnetfeldes mit harmonischer Zeitabhängigkeit gemäß $f_{mess} = |f_R - f_{mod}|$ und $H_{mess0} = H_{sup} / H_{mod0}$ berechnet wird.

4. Verfahren nach einem der vorangehenden Ansprüche, **dadurch gekennzeichnet, dass** das Magnetfeld eine Mehrzahl von Anteilen mit harmonischer Zeitabhängigkeit mit verschiedenen Magnetfeldanteilamplituden und/oder Magnetfeldanteilfrequenzen im Intervall $f_{min} < f_{mess} < f_{max}$ aufweist und eine Mehrzahl von Modulationsfrequenzen in einem komplementären Frequenzintervall ermittelt werden, die den Sensor in die mechanische Resonanz führen,

7

wobei jeder ermittelten Modulationsfrequenz genau eine Magnetfeldanteilfrequenz und jeder in Resonanz gemessenen Magnetfeldstärke genau eine Magnetfeldanteilamplitude zugeordnet wird.

5. Verfahren nach einem der vorangehenden Ansprüche, **dadurch gekennzeichnet, dass** $H_{mod0}$ dem Betrage nach kleiner oder gleich dem Betrag einer Feldstärke $H_B$ eingerichtet wird, wobei die Magnetostriktionskennlinie des Sensor bei der Feldstärke $\pm H_B$ ihre Wendepunkte aufweist.

6. Vorrichtung konfiguriert zur Durchführung des Verfahrens nach einem der Ansprüche 1 bis 3 für ein Magnetfeld, das eine harmonische Zeitabhängigkeit mit der vorbekannten Frequenz $f_M$ aufweist, **gekennzeichnet durch** ein Array umfassend eine Anzahl N magnetoelektrischer Sensoren mit vorbekannten mechanischen Resonanzfrequenzen $f_R(i)$, i = 1, ..., N und eine Einrichtung konfiguriert zum Superponieren des Magnetfeldes mit einem Modulationsmagnetfeld mit der änderbaren Frequenz $f_{mod} = f_R(i) + f_M$ oder $f_{mod} = f_R(i) - f_M$, die den **durch** Index i bezeichneten Sensor zur Detektion des Magnetfeldes bestimmt.

## Claims

1. A method for measuring a time-variant magnetic field using a magnetoelectric sensor having a mechanical resonant frequency $f_R$, the magnetic field comprising at least one component having a harmonic time dependence with the measuring signal amplitude $H_{mess0}$ to be determined and the measuring signal frequency $f_{mess}$ to be determined in a known frequency interval $f_{min} < f_{mess} < f_{max}$, **characterized by** the following steps:

   a. superimposing the magnetic field with a modulation magnetic field having a harmonic time dependence with the known modulation amplitude $H_{mod0}$ and a selectable modulation frequency on the sensor,
   b. varying (wobbling) the modulation frequency over a complementary frequency interval determined by the known interval limits $f_{min}$, $f_{max}$ and the resonant frequency of the sensor $f_R$,
   c. measuring the sensor signal for each selected modulation frequency,
   d. searching for the at least one modulation frequency $f_{mod}$, which results in a sensor signal in the mechanical resonance of the sensor,
   e. calculating the measuring signal frequency $f_{mess}$ from the previously determined modulation frequency $f_{mod}$ and from the resonant frequency of the sensor $f_R$
   f. translating the sensor signal at the modulation frequency $f_{mod}$ into the superimposed magnetic field amplitude $H_{sup}$,
   g. calculating the measuring signal amplitude $H_{mess0}$ from the superimposed magnetic field amplitude $H_{sup}$ and the modulation amplitude $H_{mod0}$.

2. The method according to Claim 1, **characterized in that** the operating point of the sensor in its magnetostriction characteristic is established such that its frequency response in the leading order is a square function of the magnetic field strength.

3. The method according to Claim 2, **characterized in that** the complementary frequency interval is established according to $f_R - f_{max} < f_{mod} < f_R - f_{min}$ or $f_R + f_{min} < f_{mod} < f_R + f_{max}$ and the at least One component of the magnetic field with the harmonic time dependence is calculated according to $f_{mess} = |f_R - f_{mod}|$ and $H_{mess0} = H_{sup} / H_{mod0}$.

4. The method according to one of the preceding claims, **characterized in that** the magnetic field exhibits a plurality of components having a harmonic time dependence with different magnetic field component amplitudes and/or magnetic field component frequencies in the interval $f_{min} < f_{mess} < f_{max}$ and a plurality of modulation frequencies are determined in a complementary frequency interval that leads the sensor into the mechanic resonance, each determined modulation frequency being assigned precisely one magnetic field component frequency and each magnetic field strength measured in resonance [being assigned] precisely one magnetic field component amplitude.

5. The method according to one of the preceding claims, **characterized in that** the absolute value of $H_{mod0}$ is set up to be smaller than or equal to the absolute value of a field strength $H_B$, the magnetostriction characteristic of the sensor having its inflection points at the field strength $\pm H_B$.

6. Apparatus configured for implementing the method according to claim 1 - 3 for a magnetic field having a harmonic time dependence with known frequency $f_M$, **characterized by** an array comprising a number N of magnetoelectric sensors with known mechanical resonant frequencies $f_R(i)$, i = 1, ..., N and an arrangement configured for superimposing the magnetic field with a modulation magnetic field with an alterable frequency $f_{mod} = f_R(i) + f_M$ or $f_{mod} = f_R(i) - f_M$, which determines the sensor with index i for detecting the magnetic field.

## Revendications

1. Procédé pour mesurer un champ magnétique variable dans le temps au moyen d'un capteur magnéto-électrique présentant une fréquence de résonance mécanique $f_R$, le champ magnétique comprenant au moins une composante présentant dans un intervalle de fréquences déjà connu $f_{min} < f_{mess} < f_{max}$ une dépendance temporelle harmonique par rapport à l'amplitude $H_{mess0}$ du signal de mesure à déterminer et à la fréquence $f_{mess}$ du signal de mesure à déterminer, **caractérisé par** les étapes suivantes :

   a) superposition du champ magnétique à un champ magnétique de modulation présentant une dépendance temporelle harmonique par rapport à l'amplitude de modulation $H_{mess0}$ déjà connue et une fréquence de modulation sélectionnable sur le capteur,
   b) variation, modulation, de la fréquence de modulation sur un intervalle de fréquences complémentaire déterminé par les limites d'intervalle $f_{min}$, $f_{max}$ déjà connues et la fréquence de résonance du capteur $f_R$,
   c) mesure du signal de capteur pour chaque fréquence de modulation sélectionnée,
   d) recherche de la ou des fréquences de modulation $f_{mod}$ conduisant à un signal de capteur dans la résonance mécanique du capteur,
   e) calcul de la fréquence $f_{mess}$ du signal de mesure à partir de la fréquence de modulation $f_{mod}$ déterminée auparavant et à partir de la fréquence de résonance $f_R$ du capteur,
   f) transposition du signal de capteur à la fréquence de modulation $f_{mod}$ dans l'amplitude de champ magnétique superposée $H_{sup}$,
   g) calcul de l'amplitude $H_{mess0}$ du signal de mesure à partir de l'amplitude de champ magnétique superposée $H_{sup}$ et de l'amplitude de modulation $H_{mod0}$.

2. Procédé selon la revendication 1, **caractérisé en ce que** le point de fonctionnement du capteur dans sa caractéristique de magnétostriction est défini de sorte que sa tension de réponse dans l'ordre dominant dépend de manière quadratique de l'intensité de champ magnétique.

3. Procédé selon la revendication 2, **caractérisé en ce que** l'intervalle de fréquence complémentaire est défini selon $f_R - f_{max} < f_{mod} < f_R - f_{min}$ ou $f_R + f_{min} < f_{mod} < f_R + f_{max}$ et la ou les composantes du champ magnétique présentant une dépendance temporelle harmonique sont calculées selon $f_{mess} = |f_R - f_{mod}|$ et $H_{mess0} = H_{sup} / H_{mod0}$.

4. Procédé selon l'une des revendications précédentes, **caractérisé en ce que** le champ magnétique comprend une pluralité de composantes présentant une dépendance temporelle harmonique par rapport à différentes amplitudes de champ magnétique et/ou fréquences de composante de champ magnétique dans l'intervalle $f_{min} < f_{mess} < f_{max}$ et une pluralité de fréquences de modulation dans un intervalle de fréquences complémentaire sont déterminées, lesquelles guident le capteur dans la résonance mécanique, une seule fréquence de composante de champ magnétique étant associée à chaque fréquence de module déterminée et une seule amplitude de composante de champ magnétique étant associée à chaque intensité du champ magnétique mesurée dans la résonance.

5. Procédé selon l'une quelconque des revendications précédentes, **caractérisé en ce que** la valeur absolue de $H_{mod0}$ est ajustée pour être inférieure ou égale à la valeur d'une intensité de champ $H_B$, la courbe caractéristique de magnétostriction du capteur présentant ses points d'inflexion à l'intensité de champ $\pm H_B$.

6. Dispositif configuré pour mettre en oeuvre le procédé selon l'une des revendications 1 à 3 pour un champ magnétique qui comprend une dépendance temporelle harmonique présentant la fréquence $f_M$ déjà connue, **caractérisé par** un ensemble comportant un nombre N de capteurs magnétoélectriques présentant des fréquences de résonance mécaniques $f_R(i)$, i = 1, ..., N déjà connues et un dispositif configuré pour superposer le champ magnétique à un champ magnétique de modulation présentant la fréquence variable $f_{mod} = f_R(i) + f_M$ ou $f_{mod} = f_R(i) - f_M$, qui détermine le capteur désigné par l'indice i pour la détection du champ magnétique.

Fig. 1

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100015918 A1

- US 7023206 B2

**In der Beschreibung aufgeführte Nicht-Patentliteratur**

- **ALAN S. EDELSTEIN et al.** Approach for sub pT, Room Temperature Magnetic Sensors. *Sensors, 2010 IEEE, IEEE, Piscataway, NJ, USA,* 01. November 2010, 620-622

- Giant magnetoelectric coefficients in (Fe90Co10)78Sil2B10-AlN thin film composites. **GREVE, HENRY et al.** Applied physics letters. AIP, American Institute of Physics, 03. Mai 2010, 182501-182501
- **ZHAI et al.** Giant magnetoelectric effect in Metglas/polyvinylidene-fluoride laminates. *APPLIED PHYSICS LETTERS,* 2006, vol. 89, 083507